# EUROPÄISCHE PATENTSCHRIFT

(11) **EP 1 543 542 B1**
(45) Veröffentlichungstag und Bekanntmachung des Hinweises auf die Patenterteilung: **24.06.2009**
(21) Anmeldenummer: 03779796.6
(22) Anmeldetag: 27.09.2003
(51) Int. Cl.: H01L 21/00

(54) **VORRICHTUNG UND VERFAHREN ZUR AUFBRINGUNG VON HALBLEITERCHIPS AUF TRÄGERN**
DEVICE AND METHOD FOR APPLYING SEMICONDUCTOR CHIPS TO CARRIERS
DISPOSITIF ET PROCEDE POUR APPLIQUER DES PUCES SEMI-CONDUCTRICES SUR DES SUPPORTS

(30) Priorität: 28.09.2002 DE 10245398
(43) Veröffentlichungstag der Anmeldung: 22.06.2005
(73) Patentinhaber: Mühlbauer AG, 93426 Roding (DE)
(72) Erfinder: NIKLAS, Sigmund, 93199 Zell (DE); WECKERLE, Ewald, 93173 Wenzenbach (DE); TIMM, Uwe, 81737 München (DE)
(74) Vertreter: Hannke, Christian
(86) Internationale Anmeldenummer: PCT/EP2003/010778
(87) Internationale Veröffentlichungsnummer: WO 2004/032202

(56) Entgegenhaltungen:
- EP-A- 1 170 788
- EP-A- 1 254 938
- US-B1- 6 426 552

## Beschreibung

Die Erfindung betrifft eine Vorrichtung und ein Verfahren zur Aufbringung von Halbleiterchips auf eine Mehrzahl von Trägern, insbesondere Smartcard-Modulen und Flexboards gemäß den Oberbegriffen der Patentansprüche 1 und 10.

Vorrichtungen zur Aufbringung von Halbleiterchips auf Trägern, insbesondere von Flipchips auf Smartcard-Modulen oder Flexboards weisen üblicherweise eine erste Klebstoffauftrageinrichtung zum Auftragen von Klebstoff an vorbestimmten Trägerpositionen auf den Trägern, eine zweite Bestückungseinrichtung zum Bestücken der Träger an den Trägerpositionen mit Flipchips und eine dritte Aushärteeinrichtung zum Aushärten des Klebstoffs auf. Die zu flippenden Chips werden hierbei während des Bestückungsvorganges kopfüber auf die Träger aufgesetzt, so dass an den Flipchips angebrachte Bumps mit dem Trägermaterial kontaktieren und während des Aushärtevorgangs durch Aushärten des zuvor aufgebrachten Klebers mit dem Trägermaterial verbunden werden können.

Die verschiedenen Einrichtungen sind entlang eines Transportweges hintereinander angeordnet und weisen unterschiedliche Prozesszeiten in Abhängigkeit von den durch sie durchzuführenden Bearbeitungen und/oder Kontrollen an den Trägern und/oder den Halbleiterchips auf. Hierdurch wird beispielsweise aufgrund der vergleichsweise langen Aushärtezeit der Aushärteeinrichtung eine von der Bestückungseinrichtung vorgegebene Bestückungsgeschwindigkeit zwangsläufig reduziert, da sich ansonsten die bereits bestückten Träger vor der Aushärteeinrichtung auf dem Transportweg stauen würden. Dies hat wiederum eine Reduzierung des Durchsatzes der gesamten Vorrichtung zur Folge.

Zudem ist eine zuverlässige Kontrolle der Bestückungspositionen aufgrund langer Kontrollzeiten und langer Transportwege nicht möglich.

Herkömmlicherweise wird zum Aufeinanderabstimmen der verschiedenen Prozesszeiten die Bestückungsgeschwindigkeit der Bestückungseinrichtung derart reduziert, dass die Bestückungszeit der Aushärtezeit angepasst ist. Das Auftragen eines Klebstoffs in Form eines Epoxydots auf einen Träger dauert beispielsweise 300 ms pro Träger. Die Bestückungseinrichtung benötigt eine Zeitspanne von 600 ms pro Bestückung und der Aushärtevorgang als Finalbondvorgang nimmt 10 s in Anspruch. Demzufolge wird bei einer schrittweisen Fortbewegung eines als Transportband ausgebildeten Transportweges, auf dem die Träger hintereinander angeordnet sind, um jeweils einen Indexschritt in Transportrichtung die Transportgeschwindigkeit auf 10 s pro Indexschritt reduziert, um eine Anpassung der kürzeren Auftrage- und Bestückungszeiten an die lange Aushärtezeit zu erreichen. Hierdurch wird der Durchsatz der Vorrichtung verringert.

Demgegenüber ist ein Aushärtevorgang mit einer Aushärtezeit, die der üblichen Bestückungszeit von beispielsweise 600 ms entspricht, aufgrund der Zusammensetzungen der bisher bekannten Klebstoffe, die eine derartig schnelle Aushärtung nicht zulassen, nicht möglich.

Bekannt sind auch Vorrichtungen, die eine Pufferzone zwischen der Bestückungseinrichtung und der Klebstoffauftrageinrichtung auf der einen Seite und der Aushärteeinrichtung auf der anderen Seite vorsehen. Derartige Pufferzonen dienen dazu, die bereits bestückten Träger in einer Art Warteschleife solange warten zulassen, bis sie in der Aushärteeinrichtung, die mehrere Bearbeitungseinheiten in Form eines Thermodenfeldes zum gleichzeitigen Aushärten mehrerer Träger mit Klebstoffauftragung aufweist, in größerer Zahl zugeführt werden können.

Die in dem Thermodenfeld angeordneten Bearbeitungseinrichtungen stellen einzelne Thermoden dar und sind hierfür zweidimensional, also in X- und Y-Richtung, angeordnet. Die Anzahl der Thermoden richtet sich danach, wie lange die Aushärtezeit im Vergleich zur Bestückungszeit ist. Ist beispielsweise die Aushärtezeit 9,6 s und die Bestückungszeit 600 ms, dann sind in dem Thermodenfeld insgesamt 16 Thermoden zur gleichzeitigen Bearbeitung der Träger vorgesehen. Auf diese Weise kann zwar ein hoher Durchsatz der Vorrichtung aufrechterhalten werden, jedoch wird die Prozessgenauigkeit der gesamten Vorrichtung nachteilig durch die Pufferzone aufgrund zusätzlicher Transportwege beeinflusst. Die langen Transportwege verhindern zudem die Verwendung dünnflüssiger Klebstoffe.

Weiterhin ist eine Vorrichtung bekannt, bei der während des Aushärtevorgangs mittels eines Thermodenfeldes mehrere Träger mit Klebstoffauftragung gleichzeitig ausgehärtet werden, während die Träger und das sie tragende Transportband nicht fortbewegt werden. Zur gleichen Zeit wird eine Mehrzahl von Träger mittels der Bestückungseinrichtung bei stillstehendem Transportband bestückt. Eine derartige Vorrichtung erfordert jedoch ebenso eine Reduzierung der Bestückungsgeschwindigkeit, da lange Transportwege für die gleichzeitige Bestückung mehrerer Träger erforderlich sind. Zudem wird aufgrund der langen Transportwege die Prozessgenauigkeit der gesamten Vorrichtung reduziert.

Aus der EP 1 170 787 A1 ist eine Vorrichtung und ein Verfahren zur Montage von Halbleiterchips auf einem flexiblen Substrat bekannt, wobei die Vorrichtung das Substrat in Transportrichtung gesehen zuerst von einer Auflageplatte und anschließend von einer Heizplatte getragen wird. Die Heizplatte wird zum Weitertransport des Substrats in Transportrichtung verschoben, während sie durch ihre Heizfunktion den auf das Substrat aufgebrachten Klebstoff aushärtet. Eine derartige Vorrichtung weist ebenso einen geringen Durchsatz auf, da jedes Substrat ohne zu Hilfenahme eines Transportbandes zuerst von der Auflageplatte und anschließend von der Heizplatte transportiert werden muss.

Demzufolge liegt der vorliegenden Erfindung die Aufgabe zugrunde, eine Vorrichtung und ein Verfahren zur Aufbringung von Halbleiterchips auf Trägern zur Verfügung zu stellen, bei der/dem ein hoher Durchsatz mit hoher Bestückungsgeschwindigkeit trotz der Anordnung mindestens einer Einrichtung mit zu einer Bestückungszeit vergleichsweise langen Prozesszeit unter Beibehaltung einer hohen Prozessgenauigkeit möglich ist.

Diese Aufgabe wird vorrichtungsseitig gemäß den Merkmalen des Patentanspruches 1 und verfahrensseitig gemäß den Merkmalen des Patentanspruches 10 gelöst.

Ein wesentlicher Punkt der Erfindung liegt darin, dass bei einer Vorrichtung zur Aufbringung von Halbleiterchips auf einer Mehrzahl von Trägern, insbesondere Smartcard-Modulen oder Flexboards, in der an einer Klebstoffauftrageinrichtung Klebstoff an vorbestimmten Trägerpositionen auf die Träger aufgetragen, an einer Bestückungseinrichtung die Träger an den Trägerpositionen mit den Halbleiterchips bestückt und in einer Aushärteeinrichtung der Klebstoff ausgehärtet wird, die Aushärteeinrichtung mittels einer Klemmvorrichtung mit einem die Träger entlang der Einrichtungen transportierenden Transportband verbindbar und mittels einer Hubvorrichtung in Transportrichtung mit einer Transportgeschwindigkeit des Transportbandes verschiebbar sind/ist. Auf diese Weise ist unter Beibehaltung einer kurzen Bestückungszeit eine Bearbeitung durch die Aushärteeinrichtung, die eine zu der Bestückungszeit vergleichsweise lange Prozesszeit (Bearbeitungs- und/oder Kontrollzeit) aufweisen, möglich, ohne dass der Durchsatz der gesamten Vorrichtung verringert wird. Dies wird durch die Verbindung des schrittweise fortlaufenden Transportbandes und der darauf angeordneten Träger mit der Aushärteeinrichtung erreicht, welche in Ihrer Gesamtheit ebenso wie das Transportband mit der Transportgeschwindigkeit bewegt wird.

Gemäß einer bevorzugten Ausführungsform sind in der mit dem Transportband verbindbaren Aushärteeinrichtung eine Mehrzahl von Bearbeitungs- und/oder Kontrolleinheiten in Transportrichtung des Transportbandes angeordnet, die eine gleichzeitige Bearbeitung und/oder Kontrolle der mit den Halbleiterchips bestückten Trägern während ihres Transports durchführen. Wenn die Anzahl der Bearbeitungs- und/oder Kontrolleinheiten sich danach richtet, welches Vielfache eine Bearbeitungs- und/oder Kontrollzeit einer Einheit von einer Bestückungszeit ist, dann lässt sich eine gleichzeitige Bearbeitung und/oder Kontrolle der Träger bei fortlaufenden Transportband durchführen, während der Bestückungsvorgang weiterhin durchgeführt wird. Eine Abstimmung der Bestückungszeit auf die Bearbeitungs- und/oder Kontrollzeit der Einheiten ist somit nicht mehr notwendig. Dies hat die Beibehaltung des durch die Bestückungszeit vorgegebenen Durchsatzes zur Folge.

Um eine Abstimmung des Schiebevorgangs der Aushärteeinrichtung, insbesondere ihr Zurücksetzen in eine Ausgangslage, auf den Prozessablauf der gesamten Vorrichtung zu erhalten, weist die Vorrichtung eine Zeitgebereinrichtung zum Einstellen einer Zeitspanne, die der Summe aus der Bearbeitungs- und/oder Kontrollzeit einer Bearbeitungs- und/oder Kontrolleinheit und eines Zeitabschnitts entspricht, der zum Zurückverschieben der verschobenen Aushärteeinrichtung entgegen der Transportrichtung in eine Ausgangslage benötigt wird, auf.

Vorzugsweise sind in der Aushärteeinrichtung so viele Bearbeitungs- und/oder Kontrolleinheiten angeordnet, wie innerhalb deren Bearbeitungs- und/oder Kontrollzeit sich in Transportrichtung bewegende Träger mittels der Bestückungseinrichtung mit einer vorgegebenen Bestückungsgeschwindigkeit bestückt werden können. Somit ist eine fortlaufende Bearbeitung/Kontrolle der Träger und der Halbleiterchips ohne Zuhilfenahme einer Pufferzone bei hohem Durchsatz möglich.

Gemäß einer bevorzugten Ausführungsform umfasst die verschiebbare Aushärteeinrichtung als Bearbeitungseinheiten ein oberhalb des Transportbandes angeordnetes Thermodenfeld mit einer Mehrzahl von den Trägerpositionen der Träger zugeordneten Thermoden und mindestens eine unterhalb des Transportbandes angeordnete Heizplatte. Das Thermodenfeld und die Heizplatte sind mittels einer Schiebevorrichtung in senkrechter Richtung zur der Transportbandebene derart verschiebbar, dass sie bei geschlossener Klemmvorrichtung zu dem Transportband hin und von dem Transportband weg bewegbar sind. Die Mehrzahl der Thermoden ermöglicht während der Verschiebung des gesamten Thermodenfelds einschließlich der Heizplatte in Transportrichtung eine gleichzeitige Aushärtung mehrerer mit Klebstoff versehener Träger mit darauf angebrachten Halbleiterchips.

Die Klemmvorrichtung besteht aus mindestens zwei vorzugsweise an Endbereichen der verschiebbaren Aushärteeinrichtung angeordneten Klemmbackeneinheiten, deren obere und untere Klemmbacken von oben und unten an das Transportband heranführbar sind. Auf diese Weise sind die zu verbindenden Elemente, wie Träger und Halbleiterchip, im Bezug auf die Thermoden stationär angeordnet, um eine genaue Positionierung der Thermoden zu den einzelnen Trägern während des Verbindungsvorganges sicherzustellen.

Die Hubvorrichtung ist mit einem Transportbandantrieb zum schrittweisen Bewegen des Transportbandes in Transportrichtung verbunden. Dies hat zur Folge, dass eine genaue Abstimmung der Verschiebungsgeschwindigkeit der zu verschiebenden Aushärteeinrichtung auf die Transportgeschwindigkeit des Transportbandes sichergestellt ist.

Weiterhin weist die erfindungsgemäße Vorrichtung eine vorrichtungsfeste weitere Klemmvorrichtung zum Festhalten des Transportbandes während des Zurückverschiebens der verschobenen Aushärteeinrichtung entgegen der Transportrichtung auf.

Ein erfindungsgemäßes Verfahren zur Aufbringung von Halbleiterchips auf einer Mehrzahl von Trägern umfasst vorzugsweise folgende Schritte:
- Verbinden der Aushärteeinrichtung mit einem die Träger entlang der Einrichtungen transportierenden Transportband durch Schließen einer ersten Klemmvorrichtung;
- Öffnen einer vorrichtungsfesten zweiten Klemmvorrichtung zum Freigeben des sich in Transportrichtung bewegenden Transportbandes;
- Verschieben von in der Aushärteeinrichtung angeordneten Bearbeitungs- und/oder Kontrolleinheiten in eine Schließstellung in senkrechter Richtung zu der Transportbandebene hin;
- Verschieben der Aushärteeinrichtung mit einer Transportgeschwindigkeit des Transportbandes in Transportrichtung während einer gleichzeitigen Bearbeitung und/oder Kontrolle mehrerer der mit den Halbleiterchips bestückten Träger für eine vorbestimmte Bearbeitungs- und/oder Kontrollzeit mittels der Bearbeitungs- und/oder Kontrolleinheiten;
- Verschieben der Bearbeitungs- und/oder Kontrolleinheiten in eine Öffnungsstellung von der Transportbandebene weg nach Ablauf der Bearbeitungs- und/oder Kontrollzeit;
- Schließen der vorrichtungsfesten zweiten Klemmvorrichtung;
- Öffnen der ersten Klemmvorrichtung;
- Zurückverschieben der Aushärteeinrichtung entgegen der Transportrichtung in eine Ausgangstellung.

Der Schritt des Verschiebens der Bearbeitungs- und/oder Kontrolleinheiten in eine Öffnungsstellung ist aufgrund der sich mitbewegenden Aushärteeinrichtung unabhängig von einer Fortbewegung des Transportbandes in Transportrichtung durchführbar.

Zur Erzielung eines höchstmöglichen Durchsatzes entspricht die Transportgeschwindigkeit der Bestückungsgeschwindigkeit, mit welcher die Träger auf dem sich schrittweise bewegenden Transportband bestückt werden.

Weitere vorteilhafte Ausführungsformen ergeben sich aus den Unteransprüchen.

Vorteile und Zweckmäßigkeiten sind der nachfolgenden Beschreibung in Verbindung mit der Zeichnung zu entnehmen. Hierbei zeigen:
- Figuren 1a - 1d: in jeweils einer schematischen Querschnittsansicht vier verschiedene Vorrichtungen zur Aufbringung von Halbleiterchips auf Trägern gemäß dem Stand der Technik;
- Fig. 2: in einer schematischen Querschnittsansicht eine Vorrichtung zur Aufbringung von Halbleiterchips auf Trägern gemäß einer Ausführungsform der Erfindung, und
- Fig. 3: in einer perspektivischen Ansicht einen Ausschnitt der in Fig. 2 schematisch gezeigten Vorrichtung, der eine verschiebbare Aushärteeinrichtung darstellt.

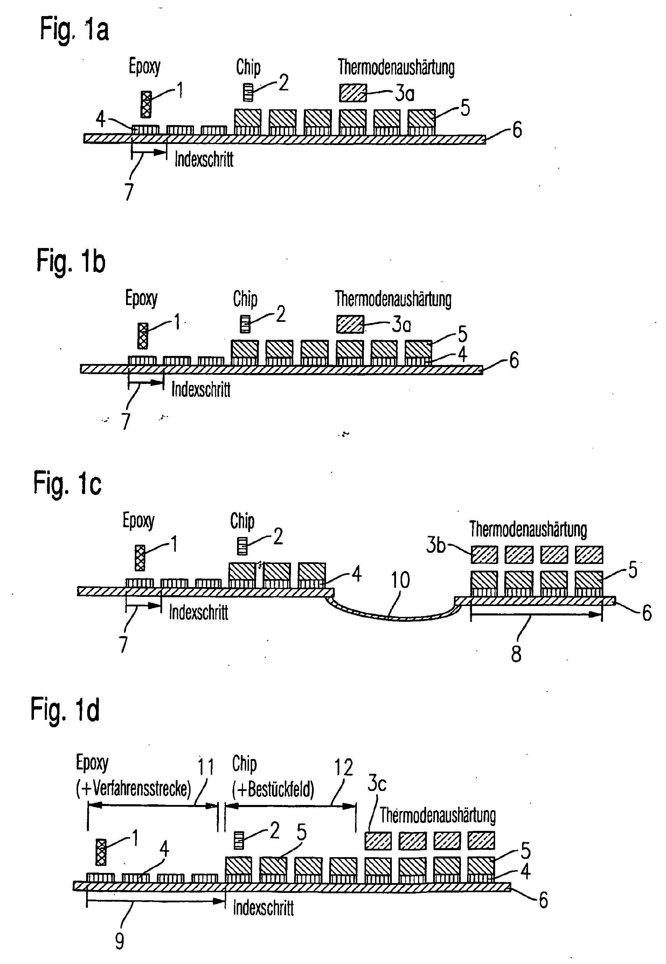

Die Figuren 1a - 1d zeigen in jeweils einer schematischen Querschnittsansicht vier verschiedene Vorrichtungen zur Aufbringung von Halbleiterchips auf Trägern gemäß dem Stand der Technik. Die in den Figuren 1a - d dargestellten Vorrichtungen setzen sich jeweils aus einer Klebstoffauftrageinrichtung 1 zum Auftragen eines Klebstoffs in Form eines Epoxydots auf Träger, eine Bestückungseinrichtung 2 zum Bestücken der Träger mit Halbleiterchips und eine Aushärteeinrichtung 3a, 3b, 3c zum Aushärten des Klebstoffs zusammen. Die Träger 4 sind auf einem Transportband 6 fortlaufend hintereinander angeordnet und bewegen sich mit diesem schrittweise jeweils um einen Indexschritt in Transportrichtung, die durch die Pfeile 7 und 9 angedeutet wird.

Die Auftragung des Klebstoffs nimmt üblicherweise 300 ms, die Bestückung mit als Flipchips ausgebildete Halbleiterchips 4 600 ms und die Thermodenaushärtung in der Aushärteeinrichtung 10 s in Anspruch.

Bei der in Figur 1a gezeigten Vorrichtung wird eine Bestückungszeit, in der ein Träger 4 mit einem Flipchip bestückt wird, an die Aushärtezeit angepasst, so dass sich eine Bestückungsgeschwindigkeit nach der wesentlich längeren Aushärtezeit richtet. Eine starke Verringerung des Durchsatzes der gesamten Vorrichtung ist die Folge.

Die in Figur 1 b dargestellte Vorrichtung weist eine Aushärteeinrichtung 3a auf, deren Aushärtezeit auf die Bestückungszeit von 600 ms reduziert ist. Dies hat zur Folge, dass der zuvor aufgetragene Klebstoff nicht zuverlässig aushärtet und somit eine zuverlässige Verbindung der mit Bumps ausgestatteten Flipchips 5 mit den Trägern 4 nicht stattfindet.

Die in Figur 1c gezeigte Vorrichtung beinhaltet eine Pufferzone 10 zwischen der Bestückungseinrichtung 2 und der Klebstoffauftrageinrichtung 1 auf der einen Seite und der Aushärteeinrichtung 3 auf der anderen Seite. In der Pufferzone 10 werden die bereits bestückten Träger 4 in einer Art Warteschleife solange warten gelassen, bis sie in die Aushärteeinrichtung 3b, die mehrere Bearbeitungseinheiten in Form eines Thermodenfeldes zum gleichzeitigen Aushärten mehrerer Träger mit Klebstoffauftragung aufweist, in größerer Zahl eingefahren werden.

Die in dem Thermodenfeld angeordneten Bearbeitungseinrichtungen stellen einzelne Thermoden dar und sind zum gleichzeitigen Aushärten möglichst vieler Klebstoffe zweidimensional, also in X- und Y-Richtung, angeordnet.

Die Aushärtezeit ist 9,6 s und die Bestückungszeit ist 600 ms. Demzufolge weist das Thermodenfeld insgesamt 16 Thermoden zur gleichzeitigen Aushärtung der Klebstoffe auf, während zeitgleich 16 neue Träger bestückt werden können. Auf diese Weise kann zwar ein hoher Durchsatz der Vorrichtung aufrechterhalten werden, jedoch wird die Prozessgenauigkeit der gesamten Vorrichtung nachteilig durch die Pufferzone aufgrund zusätzlicher Transportwege beeinflusst.

In Figur 1d wird eine Vorrichtung gezeigt, bei der während des Aushärtevorgangs mittels eines Thermodenfeldes 3c mehrere Träger 4 mit Klebstoffauftragung gleichzeitig ausgehärtet werden, während die Träger 4 und das sie tragende Transportband 6 nicht fortbewegt werden. Zur gleichen Zeit werden eine Mehrzahl von Träger 4 mittels der Bestückungseinrichtung 2 bei stillstehendem Transportband 6 bestückt. Der erforderliche Indexschritt zur schrittweisen Fortbewegung des Transportbandes 6 ist also wesentlich größer, wie es durch den Pfeil 9 angedeutet wird. Dies wird auch durch die angedeuteten Längen eines Bestückfeldes 12 und einer Klebstoffauftragverfahrensstrecke 11 angedeutet. Eine derartige Vorrichtung erfordert jedoch ebenso eine Reduzierung der Bestückungsgeschwindigkeit, da lange Transportwege für die gleichzeitige Bestückung mehrer Träger erforderlich sind. Zudem wird aufgrund der langen Transportwege die Prozessgenauigkeit der gesamten Vorrichtung reduziert.

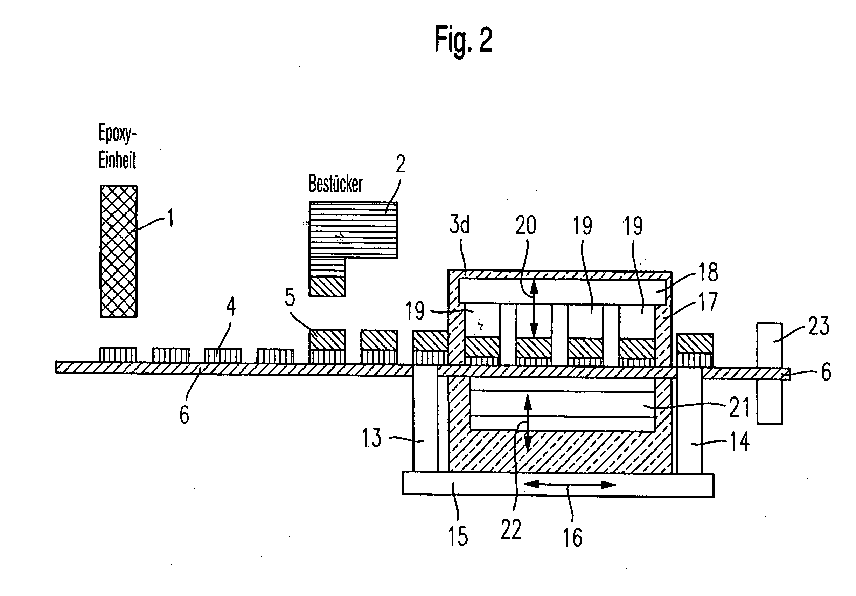

In Figur 2 wird in einer schematischen Querschnittsansicht eine Vorrichtung zur Aufbringung von Halbleiterchips auf Trägern gemäß einer Ausführungsform der Erfindung gezeigt. Die Vorrichtung weist ebenso eine Klebstoffauftrageinrichtung 1, eine Bestückungseinrichtung 2 und eine Aushärteeinrichtung 3d auf. Die Aushärteeinrichtung 3d ist mittels einer Klemmvorrichtung mit zwei endseitig angebrachten Klemmbackeneinheiten 13 und 14 mit dem Transportband 6 verbindbar. Die Klemmbackeneinheiten 13 und 14 sind mittels eines transportbandunterseitig angeordneten Verbindungselements 15 miteinander verbunden. Das Verbindungselement 15 ist mit einem hier nicht gezeigten Transportbandantrieb verbunden, der für den Transport sowohl des Transportbandes als auch der Aushärteeinrichtung 3d in Transportrichtung des Transportbandes 6 vorgesehen ist.

Die Aushärteeinrichtung 3d ist in Transportrichtung und entgegen der Transportrichtung verschiebbar, wie es durch die Pfeile 16 angedeutet ist.

Die Aushärteeinrichtung 3d setzt sich aus einem in einem Gehäuse 17 angeordneten Thermodenfeld 18 mit einzelnen Thermoden 19 zusammen, wobei die Thermoden jeweils einer Trägerposition, an der Klebstoff und ein Flipchip 5 aufgetragen worden ist, zugeordnet ist.

Die Thermoden sind entlang der Richtung des Pfeils 20 vertikal zu dem Transportband 6 hin und wieder zurück verschiebbar.

Weiterhin ist in dem Gehäuse 17 eine Heizplatte 21 an der Unterseite des Transportbandes 6 angeordnet, die sich entlang des Pfeils 22 zu dem Transportband 6 hin und von ihm weg bewegen lässt.

Die Funktionsweise der erfindungsgemäßen Vorrichtung wird anhand des nachfolgend beschriebenen Verfahrens dargestellt:
In einem ersten Schritt wird die Aushärteeinrichtung 3d mit dem Transportband durch Schließen der Klemmbackeneinheiten 13 und 14 fest verbunden.

In einem zweiten Schritt wird eine weitere vorrichtungsfeste Klemmvorrichtung 23 geöffnet, um das Transportband 6 freizugeben.

In einem dritten Schritt wird das Thermodenfeld 18 und die Heizplatte 21 gemäß den Pfeilen 20 und 22 auf das Transportband 6 zubewegt, um diese Elemente in eine Schließstellung zu bringen.

Anschließend wird in einem vierten Schritt die gesamte Aushärteeinrichtung 3d mit der Transportgeschwindigkeit des Transportbandes 6 in Transportrichtung, die in der Bildebene nach rechts verläuft, verschoben. Gleichzeitig härten die Thermoden 19 und die Heizplatte 21 die Klebstoffauftragungen an den Trägerpositionen der Träger 4 aus.

Nach abgeschlossenem Aushärtevorgang werden das Thermodenfeld 18 und die Heizplatte 21 wieder geöffnet.

Danach werden die weitere Klemmvorrichtung 23 geschlossen und die Klemmbackeneinheiten 13 und 14 geöffnet.

Anschließend wird die gesamte Aushärteeinrichtung 3d entgegen der Transportrichtung in eine Ausgangstellung zurück verschoben.

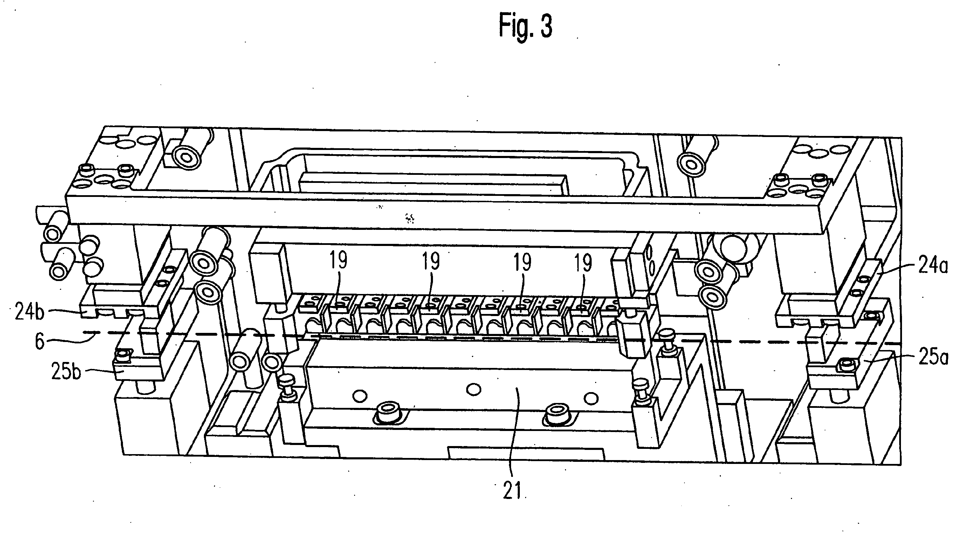

Figur 3 zeigt in einer perspektivischen Ansicht einen Ausschnitt der in Fig. 2 schematisch gezeigten Vorrichtung, der die verschiebbare Aushärteeinrichtung 3d darstellt. Dieser Darstellung ist zu entnehmen, dass die insgesamt 11 sichtbaren Thermoden 19 oberhalb des Transportbandes 6 und die Heizplatte 21 unterhalb des Transportbandes 6 angeordnet sind.

Die endseitigen Klemmbackeneinheiten setzen sich jeweils aus einer oberen Klemmbacke 24a, 24b und einer unteren Klemmbacke 25a, 25b zusammen, die in Schließstellung an die Ober- und Unterseite des Transportbandes 6 gedrückt werden.

An dieser Stelle sei darauf hingewiesen, dass alle oben beschriebenen Teile für sich allein gesehen und in jeder Kombination, insbesondere die in der Zeichnung dargestellten Details als erfindungswesentlich beansprucht werden. Abänderungen hiervon sind dem Fachmann geläufig. Beispielswiese kann die Aushärteeinrichtung durch jede beliebige Kontrolleinrichtung ersetzt werden, deren Prozesszeit ebenso die Bestückungszeit übersteigt und sich somit ein Verbinden und Verschieben der Kontrolleinrichtung mit dem Transportband anbietet.

### Bezugszeichenliste

- 1: Klebstoffauftrageinrichtung
- 2: Bestückungseinrichtung
- 3, 3a, 3b, 3c, 3d: Aushärteeinrichtung
- 4: Träger
- 5: Flipchips
- 6: Transportband
- 7, 8, 9: Transportrichtung mit Indexschritte
- 10: Pufferzone
- 11: Verfahrensstrecke
- 12: Bestückungsfeldlänge
- 13, 14: Klemmbackeneinheiten
- 15: Verbindungselement
- 16: Verschieberichtung
- 17: Gehäuse
- 18: Thermodenfeld
- 19: Thermoden
- 20, 22: Verschieberichtungen
- 21: Heizplatte
- 23: Klemmvorrichtung
- 24a, 24b: Obere Klemmbacken
- 25a, 25b: Untere Klemmbacken

## Patentansprüche

1. Vorrichtung zur Aufbringung von Halbleiterchips (5) auf einer Mehrzahl von Trägern (4), insbesondere Smartcard-Modulen oder Flexboards, wobei an einer Klebstoffauftrageinrichtung (1) Klebstoff an vorbestimmten Trägerpositionen auf die Träger (4) aufgetragen, an einer Bestückungseinrichtung (2) die Träger (4) an den Trägerpositionen mit den Halbleiterchips (5) bestückt und in einer Aushärteeinrichtung (3, 3a, 3b, 3c, 3d) der Klebstoff ausgehärtet wird,
**dadurch gekennzeichnet, daß**
die Aushärteeinrichtung (3, 3a, 3b, 3c, 3d) mittels einer Klemmvorrichtung (13, 14) mit einem die Träger (4) entlang der Einrichtungen transportierenden Transportband (6) verbindbar und mittels einer Hubvorrichtung in Transportrichtung mit einer Transportgeschwindigkeit des Transportbandes (6) verschiebbar sind/ist.

2. Vorrichtung nach Anspruch 1,
**dadurch gekennzeichnet, daß**
in der mit dem Transportband (6) verbindbaren Aushärteeinrichtung (3, 3a, 3b, 3c, 3d) eine Mehrzahl von Bearbeitungs- und/oder Kontrolleinheiten (19) in Transportrichtung des Transportbandes (6) angeordnet sind, die eine gleichzeitige Bearbeitung und/oder Kontrolle der mit den Halbleiterchips (5) bestückten Trägern (4) während ihres Transports durchführen.

3. Vorrichtung nach Anspruch 2,
**gekennzeichnet durch**
eine Zeitgebereinrichtung zum Einstellen einer Zeitspanne, die der Summe aus einer Bearbeitungs- und/oder Kontrollzeit einer Bearbeitungs- und/oder Kontrolleinheit (19) und eines Zeitabschnitts entspricht, der zum Zurückverschieben der verschobenen Aushärteeinrichtung (3, 3a, 3b, 3c, 3d) entgegen der Transportrichtung in eine Ausgangslage benötigt wird.

4. Vorrichtung nach Anspruch 3,
**dadurch gekennzeichnet, daß**
in der Aushärteeinrichtung (3, 3a, 3b, 3c, 3d) so viele Bearbeitungs- und/oder Kontrolleinheiten (19) angeordnet sind, wie innerhalb deren Bearbeitungs- und/oder Kontrollzeit sich in Transportrichtung bewegende Träger (4) mittels der Bestückungseinrichtung (2) mit einer vorgegebenen Bestückungsgeschwindigkeit bestückt werden können.

5. Vorrichtung nach einem der vorangegangenen Ansprüche,
**dadurch gekennzeichnet, daß**
die verschiebbare Aushärteeinrichtung (3d) ein oberhalb des Transportbandes (6) angeordnetes Thermodenfeld (18) mit einer Mehrzahl von den Trägerpositionen der Träger (4) zugeordneten Thermoden und mindestens eine unterhalb des Transportbandes (6) angeordnete Heizplatte (21) beinhaltet.

6. Vorrichtung nach Anspruch 5,
**dadurch gekennzeichnet, daß**
das Thermodenfeld (18) und die Heizplatte (21) mittels einer Schiebevorrichtung in senkrechter Richtung zur der Transportbandebene derart verschiebbar sind, dass sie bei geschlossener Klemmvorrichtung (13, 14) zu dem Transportband (6) hin und von dem Transportband (6) weg bewegbar sind.

7. Vorrichtung nach einem der vorangegangenen Ansprüche,
**dadurch gekennzeichnet, daß**
die Klemmvorrichtung mindestens zwei vorzugsweise an Endbereichen der verschiebbaren Aushärteeinrichtung (3, 3a, 3b, 3c, 3d) angeordnete Klemmbackeneinheiten (13, 14) umfasst, deren obere und untere Klemmbacken (24a, 25a; 24b, 25b) von oben und unten an das Transportband (6) heranführbar sind.

8. Vorrichtung nach einem der vorangegangenen Ansprüche,
**dadurch gekennzeichnet, daß**
die Hubvorrichtung mit einem Transportbandantrieb zum schrittweisen Bewegen des Transportbandes in Transportrichtung verbunden ist.

9. Vorrichtung nach einem der Ansprüche 3 - 8,
**gekennzeichnet durch**
eine vorrichtungsfeste weitere Klemmvorrichtung (23) zum Festhalten des Transportbandes (6) während des Zurückverschiebens der verschobenen Aushärteeinrichtung (3, 3a, 3b, 3c, 3d) entgegen der Transportrichtung.

10. Verfahren zur Aufbringung von Halbleiterchips (5) auf einer Mehrzahl von Trägern (4), insbesondere Smartcard-Modulen oder Flexboards, wobei an einer Klebstoffauftrageinrichtung (1) Klebstoff an vorbestimmten Trägerpositionen auf die Träger (4) aufgetragen, an einer Bestückungseinrichtung (2) die Träger (4) an den Trägerpositionen mit den Halbleiterchips (5) bestückt und in einer Aushärteeinrichtung (3, 3a, 3b, 3c, 3d) der Klebstoff ausgehärtet wird,
**gekennzeichnet durch** folgende Schritte:
- Verbinden der Aushärteeinrichtung (3, 3a, 3b, 3c, 3d) mit einem die Träger (4) entlang der Einrichtungen transportierenden Transportband (6) **durch** Schließen einer ersten Klemmvorrichtung (13, 14);
- Öffnen einer vorrichtungsfesten zweiten Klemmvorrichtung (23) zum Freigeben des sich in Transportrichtung bewegenden Transportbandes (6);
- Verschieben von in der Aushärteeinrichtung (3, 3a, 3b, 3c, 3d) angeordneten Bearbeitungs- und/oder Kontrolleinheiten (19) in eine Schließstellung in senkrechter Richtung zu der Transportbandebene hin;
- Verschieben der Aushärteeinrichtung (3, 3a, 3b, 3c, 3d) mit einer Transportgeschwindigkeit des Transportbandes (6) in Transportrichtung während einer gleichzeitigen Bearbeitung und/oder Kontrolle mehrerer der mit den Halbleiterchips (5) bestückten Träger (4) für eine vorbestimmte Bearbeitungs- und/oder Kontrollzeit mittels der Bearbeitungs- und/oder Kontrolleinheiten (19);
- Verschieben der Bearbeitungs- und/oder Kontrolleinheiten (19) in eine Öffnungsstellung von der Transportbandebene weg nach Ablauf der Bearbeitungs- und/oder Kontrollzeit;
- Schließen der vorrichtungsfesten zweiten Klemmvorrichtung (23);
- Öffnen der ersten Klemmvorrichtung (13, 14);
- Zurückverschieben der Aushärteeinrichtung (3, 3a, 3b, 3c, 3d) entgegen der Transportrichtung in eine Ausgangstellung.

11. Verfahren nach Anspruch 10,
**dadurch gekennzeichnet, daß**
der Schritt des Verschiebens der Bearbeitungs- und/oder Kontrolleinheiten (19) in eine Öffnungsstellung unabhängig von einer Fortbewegung des Transportbandes (6) in Transportrichtung durchführbar ist.

12. Verfahren nach Anspruch 10 oder 11,
**dadurch gekennzeichnet, daß**
die Transportgeschwindigkeit einer Bestückungsgeschwindigkeit, mit welcher die Träger (4) auf dem sich schrittweise bewegenden Transportband (6) bestückt werden, entspricht.

## Claims

1. An apparatus for applying semiconductor chips (5) to a plurality of substrates (4), in particular smartcard modules or flexboards, wherein at an adhesive application device (1) adhesive is applied to the substrate (4) at predefined substrate positions, at a fitting device (2) the substrate (4) is fitted with the semiconductor chips (5) at the substrate positions, and in a curing device (3, 3a, 3b, 3c, 3d) the adhesive is cured, **characterized in that** the curing device (3, 3a, 3b, 3c, 3d) can be connected by a clamping device (13, 14) to a conveyor belt (6) which transports the substrates (4) along the devices, and can be moved in the transport direction, at a transport speed of the conveyor belt (6), by a lifting device.

2. The apparatus as claimed in claim 1, **characterized in that,** in the curing device (3, 3a, 3b, 3c, 3d) which can be connected to the conveyor belt (6), a plurality of processing and/or control units (19) are arranged in the transport direction of the conveyor belt (6), which processing and/or control units carry out simultaneous processing and/or control of the substrates (4) fitted with the semiconductor chips (5) as they are transported.

3. The apparatus as claimed in claim 2, **characterized by** a timer device for setting a time duration which corresponds to the sum of a processing and/or control time of a processing and/or control unit (19) and a time period which is required to return the moved curing device (3, 3a, 3b, 3c, 3d) to a starting position in a direction counter to the transport direction.

4. The apparatus as claimed in claim 3, **characterized in that** arranged in the curing device (3, 3a, 3b, 3c, 3d) are the same number of processing and/or control units (19) as the number of substrates (4) moving in the transport direction which can be fitted by the fitting device (2) at a predefined fitting speed within the processing and/or control time.

5. The apparatus as claimed in any of the preceding claims, **characterized in that** the movable curing device (3, 3a, 3b, 3c, 3d) comprises a thermode array (18) arranged above the conveyor belt (6), said thermode array comprising a plurality of thermodes assigned to the substrate positions of the substrates (4), and at least one heating plate (21) arranged below the conveyor belt (6).

6. The apparatus as claimed in claim 5, **characterized in that** the thermode array (18) and the heating plate (21) can be moved by a slide device in a direction perpendicular to the plane of the conveyor belt in such a way that, with the clamping device (13, 14) closed, they can be moved toward the conveyor belt (6) and away from the conveyor belt (6).

7. The apparatus as claimed in any of the preceding claims, **characterized in that** the clamping device comprises at least two clamping jaw units (13, 14) which are preferably arranged at end regions of the movable curing device (3, 3a, 3b, 3c, 3d) the upper and lower clamping jaws (24a, 25a; 24b, 25b) of which can be guided toward the conveyor belt (6) from above and below.

8. The apparatus as claimed in any of the preceding claims, **characterized in that** the lifting device is connected to a conveyor belt drive for moving the conveyor belt in a step-wise manner in the transport direction.

9. The apparatus as claimed in any of claims 3 to 8, **characterized by** a further clamping device (23), fixed to the apparatus, for keeping the conveyor belt (6) stationary while the moved curing device (3, 3a, 3b, 3c, 3d) is being returned in the direction counter to the transport direction.

10. A method for applying semiconductor chips (5) to a plurality of substrates (4), in particular smartcard modules or flexboards, wherein at an adhesive application device (1) adhesive is applied to the substrate (4) at predefined substrate positions, at a fitting device (2) the substrate (4) is fitted with the semiconductor chips (5) at the substrate positions, and in a curing device (3, 3a, 3b, 3c, 3d) the adhesive is cured, **characterized by** the following steps:
- connecting the curing device (3, 3a, 3b, 3c, 3d) to a conveyor belt (6) which transports the substrates (4) along the devices, by closing a first clamping device (13, 14);
- opening a second clamping device (23), fixed to the apparatus, so as to release the conveyor belt (6) moving in the transport direction;
- moving processing and/or control units (19) arranged in the curing device (3, 3a, 3b, 3c, 3d) into a closed position in a direction perpendicular to the plane of the conveyor belt;
- moving the curing device (3, 3a, 3b, 3c, 3d) at a transport speed of the conveyor belt (6) in the transport direction during a simultaneous processing and/or control of a plurality of substrates (4) fitted with the semiconductor chips (5) for a predefined processing and/or control time by means of the processing and/or control units (19);
- moving the processing and/or control units (19) into an open position away from the plane of the conveyor belt following expiry of the processing and/or control time;
- closing the second clamping device (23) which is fixed to the apparatus;
- opening the first clamping device (13, 14);
- returning the curing device (3, 3a, 3b, 3c, 3d) to a starting position in a direction counter to the transport direction.

11. The method as claimed in claim 10, **characterized in that** the step of moving the processing and/or control units (19) into an open position can be carried out independently of a movement of the conveyor belt (6) in the transport direction.

12. The method as claimed in claim 10 or 11, **characterized in that** the transport speed corresponds to a fitting speed at which the substrates (4) on the conveyor belt (6) are fitted, said conveyor belt moving in a step-wise manner.

## Revendications

1. Dispositif pour appliquer des puces semi-conductrices (5) sur une pluralité de supports (4), en particulier des modules de carte à puce (smartcard) ou des supports électroniques flexibles (flexboards), de la colle étant appliquée sur les supports (4), en des positions de support prédéterminées, sur un dispositif d'application de colle (1), les supports (4) étant équipés des puces semi-conductrices (5) dans les positions de support sur un dispositif d'équipement (2) et la colle étant durcie dans un dispositif de durcissement (3, 3a, 3b, 3c, 3d), **caractérisé en ce que** le dispositif de durcissement (3, 3a, 3b, 3c, 3d) peut être relié, au moyen d'un dispositif de serrage (13, 14), à une bande transporteuse transportant les supports (4) le long des dispositifs et pouvant être déplacé, au moyen d'un dispositif de levage, dans la direction de transport, à une vitesse de transport de la bande transporteuse (6).

2. Dispositif selon la revendication 1, **caractérisé en ce que** dans le dispositif de durcissement (3, 3a, 3b, 3c, 3d), pouvant être relié à la bande transporteuse (6), il est disposé une pluralité d'unités d'usinage et/ou de contrôle (19) dans la direction de transport de la bande transporteuse (6), lesquelles exécutent un usinage et/ou contrôle simultané des supports (4) équipés des puces semi-conductrices (5), pendant leur transport.

3. Dispositif selon la revendication 2, **caractérisé par** un dispositif générateur de rythme pour régler un intervalle de temps, qui correspond à la somme d'un temps d'usinage et/ou de contrôle d'une unité d'usinage et/ou de contrôle (19) et d'un intervalle de temps qui est nécessaire pour repousser le dispositif de durcissement (3, 3a, 3b, 3c, 3d) déplacé, dans le sens contraire au sens de transport, dans une position initiale.

4. Dispositif selon la revendication 3, **caractérisé en ce que** dans le dispositif de durcissement (3, 3a, 3b, 3c, 3d) sont disposées autant d'unités d'usinage et/ou de contrôle (19) que de supports (4), se déplaçant dans la direction de transport, à l'intérieur de leur temps d'usinage et/ou de contrôle, qui peuvent être équipés au moyen du dispositif d'équipement (2) à une vitesse d'équipement prédéfinie.

5. Dispositif selon l'une quelconque des revendications 1 à 4, **caractérisé en ce que** le dispositif de durcissement (3d) déplaçable contient une zone de thermodes (18) disposée au-dessus de la bande transporteuse (6), avec une pluralité de thermodes associées aux positions de support des supports (4), et au moins une plaque chauffante (21) disposée au-dessous de la bande transporteuse (6).

6. Dispositif selon la revendication 5, **caractérisé en ce que** la zone de thermodes (18) et la plaque chauffante (21) peuvent être déplacées au moyen d'un dispositif de poussée dans la direction perpendiculaire au plan de la bande transporteuse, de manière que lorsque le dispositif de serrage (13, 14) est fermé elles puissent être déplacées vers la bande transporteuse (6) et à partir de la bande transporteuse (6).

7. Dispositif selon l'une quelconque des revendications 1 à 6, **caractérisé en ce que** le dispositif de serrage comprend au moins deux unités de mâchoires de serrage (13, 14) disposées dans les zones d'extrémité du dispositif de durcissement (3, 3a, 3b, 3c, 3d) déplaçable, dont les mâchoires de serrage supérieures et inférieures (24a, 35a ; 24b, 25b) peuvent être approchées depuis le haut et depuis le bas de la bande transporteuse (6).

8. Dispositif selon l'une quelconque des revendications 1 à 7, **caractérisé en ce que** le dispositif de levage est relié à un dispositif d'entraînement de bande transporteuse pour le déplacement pas à pas de la bande transporteuse dans la direction de transport.

9. Dispositif selon l'une quelconque des revendications 3 à 8, **caractérisé par** un autre dispositif de serrage (23) solidaire du dispositif pour fixer la bande transporteuse (6) pendant le recul du dispositif de durcissement (3, 3a, 3b, 3c. 3d) déplacé, dans le sens contraire au sens de transport.

10. Procédé pour appliquer des puces semi-conductrices (5) sur une pluralité de supports (4), en particulier des modules de smartcard ou des flexboards, de la colle étant appliquée sur les supports (4), en des positions de support prédéterminées, sur un dispositif d'application de colle (1), les supports (4) étant équipés des puces semi-conductrices (5) dans les positions de support sur le dispositif d'équipement (2) et la colle étant durcie dans un dispositif de durcissement (3, 3a, 3b, 3c, 3d), **caractérisé par** les étapes suivantes :
- relier le dispositif de durcissement (3, 3a, 3b, 3c, 3d) à une bande transporteuse (6), transportant les supports (4) le long des dispositifs, par fermeture d'un premier dispositif de serrage (13, 14) ;
- ouvrir un second dispositif de serrage (23) solidaire du dispositif pour libérer la bande transporteuse (6) se déplaçant dans la direction de transport ;
- déplacer des unités d'usinage et/ou de contrôle (19), disposées dans le dispositif de durcissement (3, 3a, 3b, 3c, 3d), dans une position de fermeture dans une direction perpendiculaire au plan de la bande transporteuse ;
- déplacer le dispositif de durcissement (3, 3a, 3b, 3c, 3d) à une vitesse de transport de la bande transporteuse (6) dans la direction de transport, pendant un usinage et/ou contrôle simultané de plusieurs des supports (4) équipés des puces semi-conductrices (5) pour un temps prédéterminé d'usinage et/ou de contrôle au moyen des unités d'usinage et/ou de contrôle (19) ;
- déplacer les unités d'usinage et/ou de contrôle (19) dans une position d'ouverture à partir du plan de la bande transporteuse, à l'expiration du temps d'usinage et/ou de contrôle ;
- fermer le second dispositif de serrage (23) solidaire du dispositif;
- ouvrir le premier dispositif de serrage (13, 14) ;
- repousser le dispositif de durcissement (3, 3a, 3b, 3c, 3d) dans le sens contraire au sens de transport, dans une position initiale.

11. Procédé selon la revendication 10, **caractérisé en ce que** l'étape du déplacement des unités d'usinage et/ou de contrôle (19) dans une position d'ouverture peut être exécutée indépendamment d'une avance de la bande de transport (6) dans la direction de transport.

12. Procédé selon l'une quelconque des revendications 10 ou 11, **caractérisé en ce que** la vitesse de transport correspond à une vitesse d'équipement à laquelle les supports (4) sont équipés sur la bande transporteuse (6) se déplaçant pas à pas.
